# DEMANDE DE BREVET EUROPEEN

(11) **EP 0 936 468 A1**
(43) Date de publication de la demande: **18.08.1999**
(21) Numéro de dépôt: 99400208.7
(22) Date de dépôt: 29.01.1999
(51) Int. Cl.: G01R 1/067

(54) **Dispositif formant testeur à pointe de touche rétractable**

(30) Priorité: 10.02.1998 FR 9801550
(71) Demandeur: CHAUVIN ARNOUX, 75018 Paris (FR)
(72) Inventeur: Arnoux, Daniel, 75018 Paris (FR); Arnoux, Axel, 75018 Paris (FR); Gentier, Claude, 75018 Paris (FR); Piaud, Didier, 92370 Chaville (FR)
(74) Mandataire: Thinat, Michel

(57) **Abrégé**

La présente invention concerne un dispositif formant testeur à pointe de touche rétractable.

Le dispositif est caractérisé en ce que le fourreau de protection (5) est monté coulissant dans un boîtier de support (9) fixé dans le corps isolant (1) et des moyens à billes (10) sont prévus dans le boîtier de support (9) pour transformer un enfoncement de l'organe d'actionnement (7) en un déplacement positif du fourreau (5) de sa position rétractée de repos dans le corps (1) à sa position sortie de service de celui-ci.

L'invention trouve application dans le domaine des appareils de mesure.

## Description

La présente invention concerne un dispositif formant testeur à pointe de touche rétractable.

Un tel dispositif est connu par exemple par le brevet français N° 2 630 219.

Ce dispositif connu comprend un corps en matière isolante, une pointe de touche permettant d'établir un contact pour le contrôle, par exemple, d'une tension, et un fourreau de protection qui est monté mobile, à l'encontre d'un moyen élastique de rappel, entre une position déployée de repos à laquelle le fourreau s'étend au-delà de l'extrémité de la pointe de touche et une position rétractée de service à laquelle le fourreau dégage au moins partiellement l'extrémité de la pointe de touche. Ce dispositif comprend en outre un organe lié axialement au fourreau de protection et manoeuvrable manuellement pour déverrouiller le fourreau de sa position déployée de repos et assurer le déplacement de ce fourreau de sa position déployée de repos à sa position rétractée de service de manière à dégager l'extrémité de la pointe de touche.

Cependant, ce dispositif connu exige d'exercer sur l'organe de manoeuvre deux opérations, l'une d'enfoncement de cet organe pour déverrouiller le fourreau de protection et l'autre de translation vers l'arrière du corps du testeur pour amener le fourreau de protection à sa position rétractée de service. De plus, les moyens situés dans le corps du testeur pour verrouiller/déverrouiller, par l'organe de manoeuvre, le fourreau de protection, sont relativement complexes et en tout cas très sensibles à un déverrouillage de ce fourreau puisqu'une légère pression d'enfoncement exercée sur l'organe de manoeuvre libère le fourreau.

La présente invention propose un dispositif formant testeur agencé de façon à éliminer les inconvénients ci-dessus du testeur connu.

A cet effet, le dispositif formant testeur comprenant un corps en matière isolante ; une pointe de touche permettant d'établir un contact ; et un fourreau de protection porté par le corps en entourant la pointe de touche et qui est monté mobile relativement au corps, sous le contrôle d'un organe d'actionnement et à l'encontre d'un moyen élastique de rappel, entre une position de repos à laquelle la pointe de touche est rétractée dans le corps et une position de service à laquelle la pointe de touche est sortie du corps pour établir un contact, est caractérisé en ce que le fourreau de protection est monté coulissant dans un boîtier de support fixé dans le corps isolant et des moyens sont prévus dans le boîtier de support pour transformer un enfoncement de l'organe d'actionnement en un déplacement positif du fourreau de protection de sa position rétractée de repos dans le corps à sa position sortie de service de ce corps.

De préférence, la pointe de touche est solidaire du fourreau de protection et a son extrémité de contact faisant saillie du fourreau (de 3,5 mm).

Les moyens de transformation précités sont disposés dans un logement longitudinal du boîtier de support dans lequel est monté coulissant, de façon guidée, le fourreau de protection, en étant situés dans le prolongement du fourreau en appui entre une extrémité de ce dernier, opposée à l'extrémité de contact de la pointe de touche, et une paroi d'extrémité du boîtier de support, et sont agencés de manière à constituer une butée de fin de course du fourreau de protection en position rétractée de repos de celui-ci à laquelle il est maintenu par le moyen élastique de rappel.

Avantageusement, une plaque formant bras de levier d'actionnement est montée pivotante par exemple à l'une de ses extrémités au boîtier de support à l'opposé de la paroi d'extrémité de celui-ci et est disposée au-dessus d'une fenêtre supérieure longitudinale du boîtier de support permettant d'accéder aux moyens de transformation, de façon à pivoter lors de l'enfoncement de l'organe d'actionnement pour pénétrer au moins en partie dans la fenêtre et agir sur les moyens de transformation pour qu'ils provoquent un déplacement axial du fourreau de protection et de la pointe de touche à leur position sortie de service.

Selon un premier mode de réalisation préféré, les moyens de transformation comprennent des billes emprisonnées dans le logement du boîtier de support et réparties en deux rangées superposées respectivement supérieure et inférieure suivant l'axe longitudinal du boîtier de support, les billes de chaque rangée étant maintenues intimement en contact les unes avec les autres dans le logement suivant une force axiale exercée par le moyen élastique de rappel et le fourreau de protection de manière à constituer la butée de fin de course précitée du fourreau en position rétractée de repos de celui-ci, avec chaque bille de la rangée supérieure supportée par deux billes consécutives de la rangée inférieure et maintenue par celles-ci en appui sous des parties correspondantes des deux bords longitudinaux de la fenêtre, de sorte qu'en enfonçant l'organe d'actionnement, la plaque pivotante exerce sur les billes de la rangée supérieure un effort tendant à écarter les unes des autres les billes de la rangée inférieure à l'encontre du moyen élastique de rappel pour provoquer le déplacement axial du fourreau de protection et de la pointe de touche à leur position sortie de service.

Selon un deuxième mode de réalisation, les moyens de transformation comprennent une chaîne de rouleaux reliés entre eux de façon articulée à leurs extrémités par des maillons et emprisonnés dans le logement transversalement à l'axe longitudinal du boîtier de support pour définir des rouleaux inférieurs en appui au fond du logement et des rouleaux supérieurs en appui sous des parties correspondantes des deux bords longitudinaux de la fenêtre en position rétractée de repos du fourreau de protection à laquelle la chaîne est rigide suivant l'axe longitudinal du boîtier de support pour former la butée de fin de course précitée, de sorte qu'en enfonçant l'organe d'actionnement, la plaque pivotante exerce sur les rouleaux supérieurs un effort tendant à aplatir la chaîne pour écarter les uns des autres les rouleaux inférieurs, à l'encontre du moyen élastique de rappel, et provoquer ainsi le déplacement axial du fourreau de protection et de la pointe de touche à leur position de sortie de service.

Selon un troisième mode de réalisation, les moyens de transformation comprennent une lame ondulée élastiquement déformable suivant une direction perpendiculaire à son plan médian longitudinal et emprisonnée dans le logement précité en étant disposée longitudinalement dans celui-ci suivant l'axe longitudinal du boîtier de support de manière que les ondulations inférieures de la lame soient en appui au fond du logement et les ondulations supérieures de celle-ci soient en appui sous des parties correspondantes des deux bords longitudinaux de la fenêtre en position rétractée de repos du fourreau de protection à laquelle la lame ondulée est rigide suivant l'axe longitudinal du boîtier de support pour former la butée de fin de course précitée, de sorte qu'en enfonçant l'organe d'actionnement, la plaque pivotante exerce sur les ondulations supérieures un effort tendant à aplatir la lame, à l'encontre du moyen de rappel élastique, pour provoquer le déplacement axial du fourreau de protection et de la pointe de touche à leur position sortie de service.

Avantageusement, l'organe d'actionnement est en forme de bouton-poussoir solidaire de la plaque pivotante à son extrémité opposée à son axe de pivotement et fait saillie au travers d'une ouverture de la paroi supérieure du corps isolant.

Selon une variante de réalisation, l'organe d'actionnement est en forme de bouton pivotant à partie excentrée en contact sur la partie d'extrémité de la plaque pivotante opposée à son axe de pivotement et fait saillie au travers d'une ouverture de la paroi supérieure du corps isolant.

La plaque pivotante comprend en outre une nervure longitudinale à sa face inférieure en regard de la fenêtre du boîtier de support et pouvant s'engager dans la fenêtre pour actionner les moyens de transformation.

Le moyen élastique de rappel est un ressort hélicoidal de traction fixé d'une part à un ergot en saillie solidaire du fourreau de protection et traversant une fente longitudinale d'une paroi latérale du boîtier de support et d'autre part à un élément en saillie solidaire du boîtier de support à son extrémité opposée à l'extrémité de contact de la pointe de touche.

Le fourreau de protection comprend un plot faisant saillie au travers d'une autre fente longitudinale du boîtier de support et permettant de relier électriquement la pointe de touche à un cordon électrique.

Selon une variante de réalisation, le ressort de traction, en matériau électriquement conducteur, a son extrémité fixée à l'élément en saillie du fourreau de protection reliée électriquement à la pointe de touche et son extrémité opposée fixée au boîtier de support est reliée électriquement à un cordon électrique.

Le corps isolant a une partie formant nez dans laquelle est montée à coulissement une partie du fourreau de protection faisant saillie du boîtier de support et l'extrémité de contact de la pointe de touche fait saillie du fourreau de protection d'une distance telle qu'en position rétractée de repos du fourreau, elle est escamotée dans la partie formant nez du corps isolant.

De préférence, le boîtier de support est constitué de deux demi-boîtiers fixés amoviblement l'un à l'autre par des vis.

L'invention sera mieux comprise et d'autres buts, caractéristiques, détails et avantages de celle-ci apparaîtront plus clairement dans la description explicative qui va suivre faite en référence aux dessins schématiques annexés donnés uniquement à titre d'exemple illustrant un mode de réalisation de l'invention et dans lesquels :

La figure 1 est une vue en perspective éclatée du dispositif formant testeur de l'invention.

La figure 2 est une vue en perspective éclatée d'un ensemble de l'invention comprenant un boîtier de support, une pointe de touche et un fourreau de protection rétractables, du dispositif testeur de la figure 1.

La figure 3 est une autre vue en perspective éclatée suivant la flèche III de l'ensemble de la figure 2.

La figure 4 est une vue en perspective assemblée de l'ensemble des figures 2 et 3.

La figure 5 est une vue en coupe du dispositif suivant la ligne V-V de la figure 1 et représentant la pointe de touche en position rétractée de repos.

La figure 6 est une vue en coupe suivant la ligne VI-VI de la figure V.

La figure 7 est une vue en coupe suivant la ligne VII-VII de la figure 5.

La figure 8 est une vue en coupe suivant la ligne VIII-VIII de la figure 5.

La figure 9 est une vue en coupe suivant la ligne IX-IX de la figure 5.

La figure 10 est une vue en coupe semblable à celle de la figure 5 et représentant la pointe de touche en position sortie de service.

La figure 11 est une vue en coupe suivant la ligne XI-XI de la figure 10.

La figure 12 est une vue en coupe suivant la ligne XII-XII de la figure 10.

La figure 13 est une vue en coupe suivant la ligne XIII-XIII de la figure 10.

La figure 14 est une vue en coupe suivant la ligne XIV-XIV de la figure 10.

La figure 15 est une vue en coupe semblable à celle de la figure 5 et représentant un deuxième mode de réalisation du dispositif testeur de l'invention.

La figure 16 est une vue en coupe semblable à celle de la figure 5 et représentant un troisième mode de réalisation du dispositif testeur de l'invention.

La figure 17 représente une variante de réalisation de l'organe d'actionnement faisant partie du dispositif de l'invention.

L'invention va être décrite en application à un dispositif formant testeur du type relié à l'extrémité d'un cordon électrique pour, par exemple, contrôler l'existence ou non d'une tension, mais il est bien entendu qu'elle peut également s'appliquer à tout autre type d'appareil de contrôle ou de mesure.

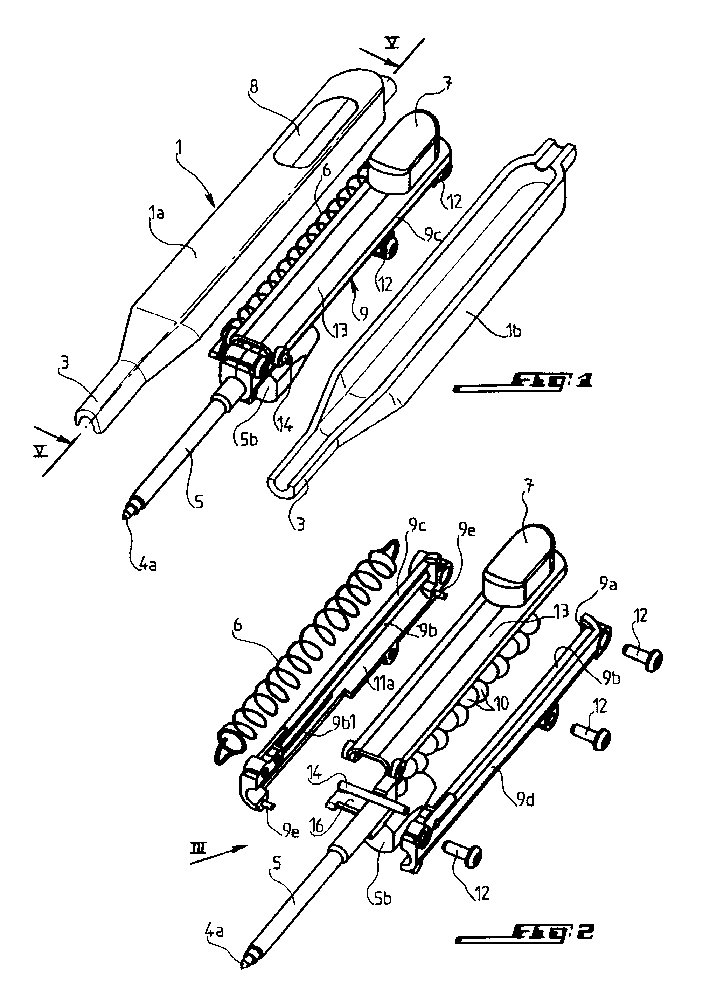

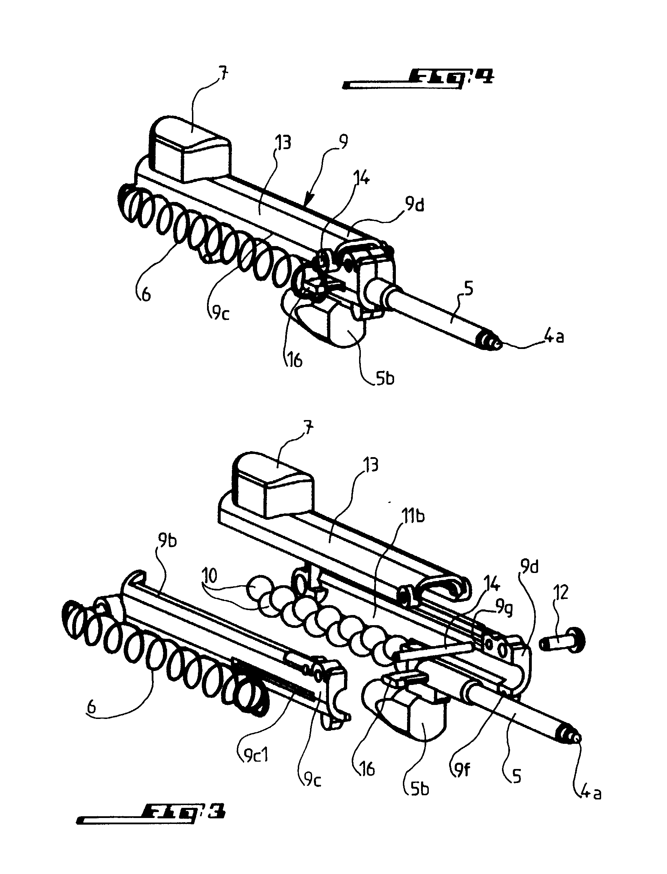

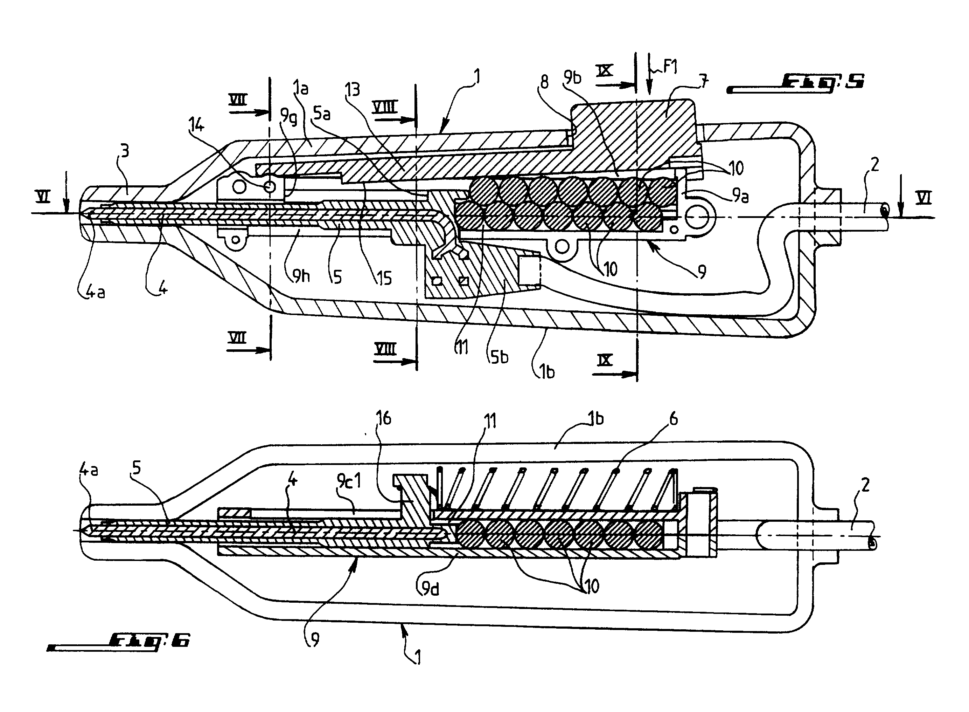

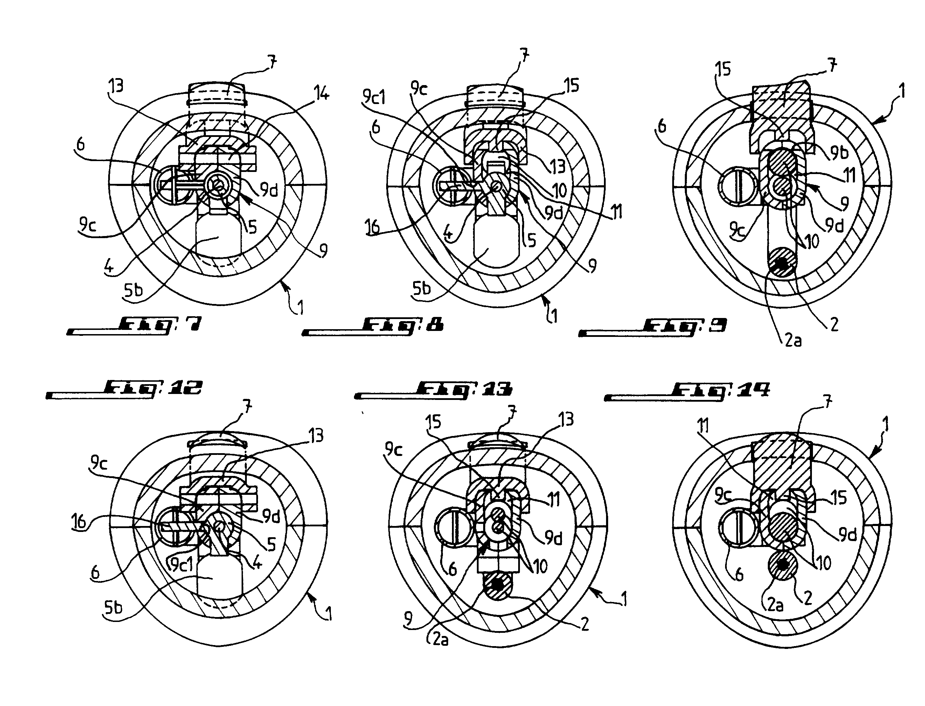

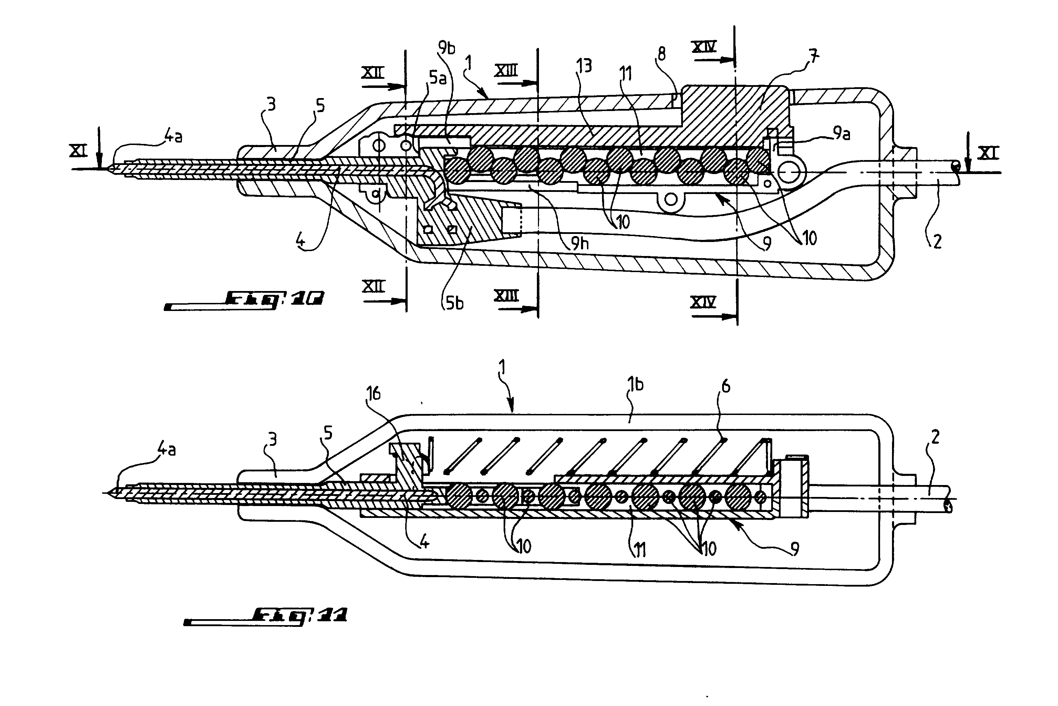

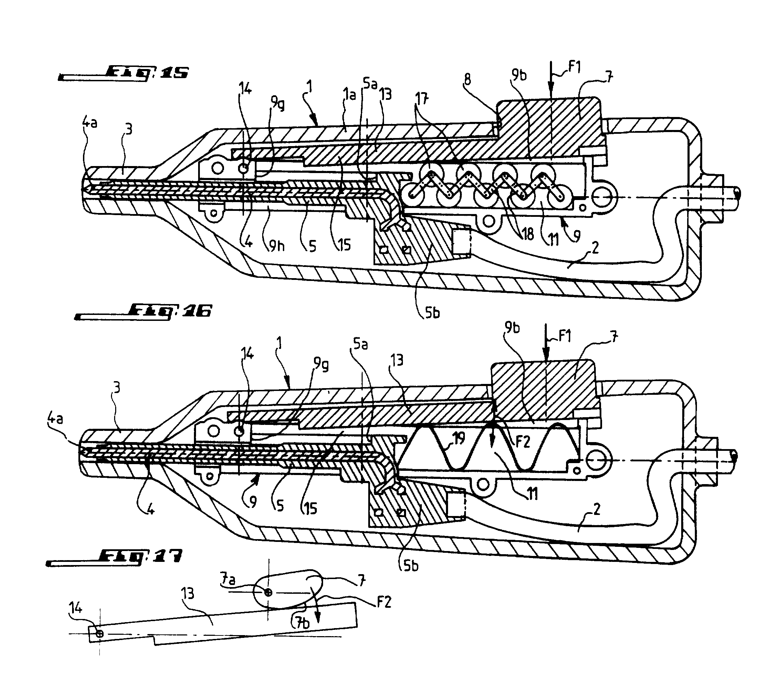

Le dispositif testeur tel que représenté tout d'abord aux figures 1 à 14 comprend un corps en matière isolante 1 constitué de deux coquilles respectivement supérieure la et inférieure 1b fixées en affrontement l'une à l'autre de façon amovible et appropriée, par exemple par collage ou soudage. En position assemblée, les deux coquilles la, 1b enserrent à une extrémité un cordon électrique 2 relié à un appareillage électrique (non représenté) et forment à l'extrémité opposée un nez tubulaire 3.

Le dispositif comprend également une pointe de touche 4 permettant d'établir un contact par son extrémité libre en pointe 4a et un fourreau de protection 5 entourant la pointe de touche 4 et qui est monté mobile dans le corps isolant 1, à l'encontre d'un moyen élastique de rappel constitué, dans le cas présent, par un ressort hélicoidal de traction 6, entre une position de repos, représentée notamment en figure 5, à laquelle la pointe de touche 4 est escamotée, c'est-à-dire inaccessible de l'extérieur, et une position sortie de service, représentée notamment en figure 10, à laquelle la pointe de touche 4 est en position sortie de service pour permettre un contact électrique par son extrémité libre.

Comme on le verra ultérieurement, la pointe de touche 4 est en contact électrique avec l'âme conductrice 2a du cordon 2.

En position assemblée des deux coquilles 1a, 1b du corps isolant 1, le nez tubulaire 3 porte de façon guidée une partie avant du fourreau de protection 5 qui entoure la pointe de touche 4.

Le dispositif comprend en outre un organe 7 faisant saillie extérieurement au travers d'un ouverture 8 réalisée dans la paroi sensiblement plane supérieure de la coquille la. Cet organe est manoeuvré manuellement pour déplacer le fourreau de protection 5 de sa position de repos à sa position de service.

Selon l'invention, le fourreau de protection 5 est monté en partie de façon coulissante dans un boîtier de support 9 fixé dans le corps isolant 1 de façon appropriée, soit en étant maintenu fermement par emboîtement dans le corps 1 après fixation l'une à l'autre des deux coquilles la, 1b, soit par des éléments de fixation, tels que des axes solidaires des deux coquilles et s'engageant dans des perçages correspondants du boîtier de support 9 en position assemblée de ces deux coquilles.

De préférence, la pointe de touche 4 est solidaire du fourreau de protection 5 de façon à être immobilisée dans celui-ci. Pour cela, le fourreau de protection 5 est surmoulé à la pointe de touche 4 qui comporte en outre à son extrémité opposée à sa pointe de contact 4a une partie coudée sensiblement à angle droit noyée dans une partie arrière de plus grande dimension du fourreau de protection 5. L'extrémité 4a de la pointe de touche 4 fait saillie du fourreau de protection 5 d'une distance déterminée telle qu'en position rétractée de repos du fourreau 5 dans le corps isolant 1, l'extrémité 4a soit escamotée dans le nez tubulaire 3 et donc protégée par celui-ci de l'extérieur pour éviter de la déplacer axialement.

Le dispositif de l'invention comprend également des moyens notamment prévus dans le boîtier de support 9 pour transformer un enfoncement de l'organe d'actionnement 7 dans le sens indiqué par la flèche F1 sensiblement perpendiculaire à l'axe longitudinal du boîtier de support 9 ou du corps isolant 1 en un déplacement positif du fourreau de protection 5 et de la pointe de touche associée 4 de leur position rétractée de repos dans le corps 1 à leur position sortie de service de celui-ci.

De préférence, les moyens de transformation comprennent des billes 10 emprisonnées dans un logement longitudinal 11 du boîtier de support 9 et dans lequel est monté coulissant, de façon appropriée, le fourreau de protection 5, les billes 10 étant situées en prolongement de ce fourreau en étant en appui d'une part entre une paroi d'extrémité arrière de celui-ci, opposée à l'extrémité de contact de la pointe de touche 4, et d'autre part une paroi d'extrémité arrière 9a du boîtier de support 9. Les billes 10 sont agencées de manière à constituer une butée de fin de course du fourreau de protection 5 en position rétractée de repos de celui-ci et à laquelle il est maintenu par le moyen élastique de rappel 6. Plus précisément, les billes 10 sont réparties en deux rangées superposées respectivement supérieure et inférieure suivant l'axe longitudinal du boîtier de support 9. Les billes 10 de chaque rangée sont maintenues intimement en contact les unes avec les autres dans le logement 11 par la force axiale dirigée suivant l'axe longitudinal du boîtier 9 et exercée par le moyen de rappel 6 sur le fourreau de protection 5 de telle manière qu'en position rétractée de repos du fourreau 5, chaque bille de la rangée supérieure supportée par deux billes consécutives 10 de la rangée inférieure soit maintenue par celles-ci en appui sous deux parties correspondantes de deux bords longitudinaux d'une fenêtre 9b réalisée longitudinalement au travers de la paroi supérieure du boîtier de support 9. Ainsi, en position rétractée de repos du fourreau de protection 5, les billes 10 forment un ensemble compact jouant le rôle d'une butée longitudinale de fin de course du fourreau de protection 5 de manière à maintenir, par l'action du moyen élastique de rappel 6, l'extrémité 4a de la pointe de touche 4 escamotée dans le nez tubulaire 3.

Le boîtier de support 9 est constitué de deux demi-boîtiers latéraux 9c, 9d affrontés l'un à l'autre suivant un plan de joint situé dans un plan perpendiculaire au plan de joint des deux coquilles la, 1b du corps isolant 1 et dans le plan médian longitudinal de ce corps. Les deux demi-boîtiers 9c, 9d sont assemblés l'un à l'autre par des pions de positionnement 9e de l'un 9c des demi-boîtiers et visibles en figure 2, pénétrant respectivement dans des perçages 9f, dont un seul est visible en figure 3, de l'autre demi-boîtier 9d. Les deux demi-boîtiers 9c, 9d sont ensuite fixés amoviblement l'un à l'autre par des vis de fixation 12. Les figures 2 et 3 représentent en 11a et 11b les deux demi-cavités longitudinales respectivement du demi-boîtier 9c et du demi-boîtier 9d définissant le logement dans lequel sont logées les billes 10.

Une plaque 13 à section transversale sensiblement en forme de U renversé à fond plat et formant un bras de levier d'actionnement, est montée pivotante à son extrémité située du côté du nez tubulaire 3 au boîtier de support 9 par l'intermédiaire d'un axe transversal 14 traversant l'extrémité du boîtier 9 en faisant saillie de part et d'autre de celui-ci de manière que ses extrémités libres s'engagent respectivement à travers les deux parties de parois latérales correspondantes de la plaque 13 pour lui permettre de pivoter au-dessus du boîtier 9. La plaque 13 forme en quelque sorte un capot situé au-dessus du boîtier 9 et confrontant la fenêtre longitudinale 9b de celui-ci à travers laquelle sont accessibles les billes 10 de la rangée supérieure. Cette plaque 13 comporte, solidaire de son extrémité opposée à celle articulée au boîtier 9, l'organe d'actionnement 7 qui forme un genre de bouton-poussoir. De préférence, l'organe 7 et la plaque pivotante 13 sont réalisées en une seule pièce par moulage. La plaque pivotante 13 comporte sous sa paroi longitudinale coiffant le boîtier 9 une nervure longitudinale 15 située en aplomb de la fenêtre supérieure 9b du boîtier de support 9 et pouvant s'engager dans celle-ci lorsque l'organe d'actionnement 7 est enfoncé dans le sens de la flèche F1 de manière à exercer sur les billes 10 de la rangée supérieure un effort tendant à écarter les unes des autres les billes 10 de la rangée inférieure comme représenté en figure 10, à l'encontre de la force de rappel du moyen élastique 6, pour provoquer un déplacement axial du fourreau relativement au boîtier 9 et au corps isolant 1 de sa position rétractée de repos en figure 5 à sa position sortie de service représentée en figure 10 à laquelle l'extrémité 4a de la pointe de touche 4 est sortie du nez 3 du corps 1 à une distance déterminée de l'extrémité du nez tubulaire 3, par exemple de 19 mm, pour lui permettre d'effectuer un contact.

En position de repos de la pointe de touche 4 et du fourreau de protection 5, les billes 10 de la rangée supérieure peuvent légèrement sortir de la fenêtre supérieure 9b de manière qu'au moins la bille supérieure 10 la plus proche du fourreau 5 contacte la plaque pivotante 13 pour la repousser en contact avec la face inférieure de la paroi supérieure de la coquille la afin qu'il n'y ait aucun jeu de débattement entre la plaque 13 et la coquille 1a.

Une fois la pointe de touche utilisée, celle-ci et le fourreau de protection 5 sont ramenés automatiquement à leur position rétractée de repos après relâchement de la pression d'enfoncement exercée sur l'organe d'actionnement 7 par le moyen élastique de rappel 6 qui force le fourreau de protection 5 à ramener par poussée les billes 10 de leur position représentée en figure 10 à leur position de contact intime les unes avec les autres et représentée en figure 5.

Le ressort 6 constituant le moyen élastique de rappel est disposé à l'extérieur du boîtier de support 9 le long d'une partie de la paroi latérale de l'un 9c des demi-boîtiers du boîtier 9 et a l'une de ses spires extrêmes ancrées à un axe externe solidaire de l'extrémité du boîtier 9 transversalement à celui-ci et qui peut être constitué par l'extrémité de la vis de fixation 12 fixant l'une à l'autre les deux extrémités des deux demi-boîtiers 9c, 9d opposées au fourreau 5. L'autre spire extrême du ressort 6 est fixée à un ergot d'ancrage 16 en forme de plaquette solidaire du corps du fourreau de protection 5 transversalement à celui-ci et traversant une fente longitudinale 9cl réalisée à travers une partie de la paroi latérale du demi-boîtier 9c du boîtier 9. L'élément 16 se déplace de façon guidée le long de la fente 9cl de la position rétractée de repos du fourreau 5 à la position sortie de service de la pointe de touche 4 lorsque l'organe d'actionnement 7 est enfoncé. Il est à noter que le fourreau 5 comporte un épaulement supérieur 5a au voisinage de sa partie arrière et venant en butée contre une partie de paroi droite interne 9g du boîtier 9 lorsque le fourreau 5 occupe la position de sortie du corps isolant 1 à laquelle la pointe de touche 4 peut être utilisée.

Le fourreau de protection 5 comprend également une partie 5b solidaire de la partie arrière du fourreau et faisant saillie du boîtier de support 9 au travers d'une fente longitudinale 9h réalisée sur une partie de la paroi de fond du boîtier 9 afin de permettre le déplacement du fourreau 5 à sa position de sortie de service de la pointe de touche 4 et formant plot de liaison électrique de l'âme conductrice 2a du cordon 2 à la partie coudée de la pointe de touche 4 par un fil conducteur noyé dans le plot et non représenté. Bien entendu, le fourreau de protection 5 est dans ce cas réalisé en un matériau électriquement isolant. Comme représenté en figure 5, la partie du cordon 2 logée dans le corps isolant 1 présente du mou en position rétractée de repos du fourreau 5 de manière que la partie de cordon interne puisse suivre le déplacement du fourreau 5 à sa position de sortie extrême du corps 1.

Le dispositif formant testeur ci-dessus décrit permet ainsi de maintenir la pointe de touche rétractée à l'intérieur du corps 1 en position de repos sous l'action du moyen élastique de rappel 6, de sorte qu'il n'y a aucun contact de l'extrémité métallique 4a de celle-ci avec l'extérieur, quelles que soient les actions mécaniques exercées sur le corps 1.

Le dispositif formant testeur du second mode de réalisation représenté en figure 15 représente le même principe de fonctionnement que celui décrit précédemment, seul les moyens de transformation proprement dits d'enfoncement de l'organe d'actionnement 7 pour le déplacement du fourreau de protection 5 et de la pointe de touche 4 étant différents.

Selon ce second mode de réalisation, les moyens de transformation comprennent une chaîne de rouleaux 17 reliés entre eux de façon articulée à leurs extrémités par des maillons 18 et emprisonnés dans le logement 11 transversalement à l'axe longitudinal du boîtier de support 9 pour définir des rouleaux inférieurs en appui au fond du logement 11 et des rouleaux supérieurs en appui sous des parties correspondantes des deux bords longitudinaux de la fenêtre supérieure 9b du boîtier 9 en position rétractée de repos du fourreau 5 dans le corps 1. A cette position, la chaîne de rouleaux 17 est rigide suivant l'axe longitudinal du boîtier 9, c'est-à-dire ne peut plus se déformer suivant cette direction, pour constituer la butée de fin de course du fourreau de protection 5. Lorsqu'un utilisateur enfonce l'organe d'actionnement 7 suivant la flèche F1, la plaque 13 pivote dans un sens faisant pénétrer la nervure longitudinale 15 dans la fenêtre 9b de façon à exercer sur les rouleaux supérieurs 17 de la chaîne de rouleaux un effort tendant à aplatir la chaîne dans le logement 11 pour écarter les uns des autres les rouleaux inférieurs 17, à l'encontre du moyen élastique de rappel 6, et provoquer ainsi le déplacement axial du fourreau de protection 5 et de la pointe de touche 4 à leur position sortie de service. A cette position, le fourreau de protection 5 est en butée sur la partie de paroi interne correspondante 9g du boîtier 9. En relâchant l'effort de poussée exercé sur l'organe d'actionnement 7, le moyen élastique 6 rappelle le fourreau de protection 5 et la pointe de touche 4 à leur position rétractée de repos dans le corps 1 avec le fourreau 5 déplaçant les rouleaux 17 de façon à rapprocher les uns des autres les rouleaux inférieurs, jusqu'à ce que la chaîne de rouleaux 17 ne puisse plus se déformer pour constituer la butée de fin de course du fourreau en position rétractée de repos de celui-ci.

Selon le troisième mode de réalisation représenté en figure 16, les moyens de transformation sont constitués par une lame ondulée 19 élastiquement déformable suivant une direction perpendiculaire à son plan médian longitudinal horizontal par rapport à la figure 16 comme indiqué par la double flèche F2. La lame ondulée 19 est emprisonnée dans le logement 11 dans la direction longitudinale de celui-ci de manière que les ondulations inférieures de celle-ci soient en appui au fond du logement 11 et les ondulations supérieures soient en appui sous des parties correspondantes des deux bords longitudinaux de la fenêtre supérieure 9b du boîtier de support 9 en position rétractée de repos du fourreau 5 et de la pointe de touche 4. A cette position de repos, la lame ondulée 19 est rigide suivant l'axe longitudinal du boîtier de support 9, c'est-à-dire ne peut plus se déformer dans cette direction pour constituer ainsi la butée de fin de course du fourreau de protection 5. En enfonçant l'organe d'actionnement 7 dans le sens de la flèche F1, le pivotement de la plaque 13 dans le sens correspondant fait pénétrer la nervure longitudinale 15 dans la fenêtre supérieure 9b du boîtier 9 de façon à exercer sur les ondulations supérieures de la lame 19 un effort tendant à aplatir celle-ci, à l'encontre du moyen de rappel élastique 6, pour provoquer le déplacement axial du fourreau de protection 5 et de la pointe de touche 4 à leur position de sortie de service hors du corps 1 à laquelle le fourreau 5 est en butée sur la paroi droite interne 9g du boîtier 9. En relâchant la pression sur l'organe d'actionnement 7, le moyen élastique 6 rappelle la pointe de touche 4 et le fourreau de protection 5 à leur position rétractée de repos dans le corps 1.

Dans les trois modes de réalisation décrits ci-dessus du dispositif formant testeur de l'invention, le cordon 2 est cinématiquement lié au fourreau de protection mobile 5, de sorte qu'il est nécessaire de prévoir une partie flexible de celui-ci dans le corps 1. Pour éviter cet inconvénient, la liaison électrique entre la pointe de touche 4 et l'âme conductrice 2a du cordon 2 peut être réalisée par le ressort de rappel 6 en matériau électriquement conducteur. A cet effet, l'âme conductrice 2a du cordon 2 est fixée, par exemple par soudage, au pion d'ancrage conducteur de la spire extrême fixe du ressort 6 et constitué par la vis de fixation 12 des parties extrêmes des deux demi-boîtiers 9c, 9d du boîtier de support 9. L'autre spire extrême mobile du ressort 6 est reliée électriquement à la pointe de touche 4 par l'ergot conducteur 16 rapporté au fourreau de protection 5 de manière que sa partie interne soit en contact électrique avec la partie correspondante de la pointe de touche 4, le fourreau 5 étant bien entendu en un matériau isolant.

Selon une variante de réalisation représentée en figure 17, l'organe d'actionnement 7 est constitué par un bouton monté pivotant autour d'un axe 7a relativement au corps 1 et comportant une partie inférieure excentrique 7b contractant la partie d'extrémité de la plaque pivotante 13 opposée à son axe de pivotement 14, le bouton 7 faisant saillie de l'ouverture 8. De la sorte, en enfonçant le bouton 7, celui-ci bascule dans le sens indiqué par la flèche F2 de manière que sa partie excentrée 7b fasse pivoter dans le même sens la plaque 13.

Le dispositif formant testeur ci-dessus décrit de l'invention permet le déplacement du fourreau de protection et de la pointe de touche de leur position rétractée de repos à leur position de sortie de service en une seule opération d'enfoncement de l'organe d'actionnement. Le dispositif est également conçu de façon qu'il n'y ait aucun contact de l'extrémité libre de la pointe de touche avec l'extérieur en position rétractée de repos de celle-ci et qu'en position de sortie de service de la pointe de touche, un effort axial exercé sur son extrémité libre ne permette pas son enfoncement dans le corps 1, puisque le pouce de la main de l'utilisateur exerçant l'effort de poussée sur l'organe d'actionnement empêche l'enfoncement de la pointe de touche.

## Revendications

1. Dispositif formant testeur comprenant un corps en matière isolante (1) ; une pointe de touche (4) permettant d'établir un contact ; et un fourreau de protection (5) porté par le corps (1) en entourant la pointe de touche (4) et qui est monté mobile relativement au corps (1), sous le contrôle d'un organe d'actionnement (7) et à l'encontre d'un moyen élastique rappel (6), entre une position de repos à laquelle la pointe de touche (4) est rétractée dans le corps (1) et une position de service à laquelle la pointe de touche (4) est sortie du corps (1) pour établir un contact, caractérisé en ce que le fourreau de protection (5) est monté coulissant dans un boîtier de support (9) fixé dans le corps (1) et des moyens (10 ; 17 ; 19) sont prévus dans le boîtier de support (9) pour transformer un enfoncement de l'organe d'actionnement (7) en un déplacement positif du fourreau de protection (5) de sa position rétractée de repos dans le corps (1) à sa position sortie de service du corps (1).

2. Dispositif selon la revendication 1, caractérisé en ce que la pointe de touche (4) est solidaire du fourreau de protection (5) et a son extrémité faisant saillie du fourreau (5).

3. Dispositif selon la revendication 1 ou 2, caractérisé en ce que les moyens de transformation (10, 17, 19) sont disposés dans un logement longitudinal (11) du boîtier de support (9) dans lequel est monté coulissant, de façon guidée, le fourreau de protection (5), en étant situés dans le prolongement du fourreau en appui entre une extrémité de celui-ci, opposée à l'extrémité de contact (4a) de la pointe de touche (4), et une paroi d'extrémité du boîtier (9) et sont agencés de manière à constituer une butée de fin de course du fourreau (5) en position rétractée de repos de celui-ci à laquelle il est maintenu par le moyen élastique de rappel (6).

4. Dispositif selon la revendication 3, caractérisé en ce qu'une plaque (13) formant bras de levier d'actionnement est monté pivotante à l'une de ses extrémités au boîtier de support (9) à l'opposé de sa paroi d'extrémité précitée et est disposée au-dessus d'une fenêtre supérieure longitudinale (9b) du boîtier de support (9) permettant d'accéder aux moyens de transformation (10 ; 17 ; 19) de façon à pivoter lors de l'enfoncement de l'organe d'actionnement (7) pour pénétrer au moins en partie dans la fenêtre (9b) et agir sur les moyens de transformation pour qu'ils provoquent un déplacement axial du fourreau de protection (5) et de la pointe de touche (4) à leur position sortie de service.

5. Dispositif selon la revendication 4, caractérisé en ce que les moyens de transformation précités comprennent des billes (10) emprisonnées dans le logement du boîtier (9) et réparties en deux rangées superposées respectivement supérieure et inférieure suivant l'axe longitudinal du boîtier (9), les billes (10) de chaque rangée étant maintenues intimement en contact les unes avec les autres dans le logement (11) suivant une force axiale exercée par le moyen élastique de rappel (6) et le fourreau de protection (5) en position rétractée de repos de ce dernier, avec chaque bille (10) de la rangée supérieure supportée par deux billes consécutives (10) de la rangée inférieure et maintenue par celles-ci en appui sous des parties correspondantes des deux bords longitudinaux de la fenêtre (9b), de sorte qu'en enfonçant l'organe d'actionnement (7) la plaque pivotante (13) exerce sur les billes (10) de la rangée supérieure un effort tendant à écarter les unes des autres les billes (10) de la rangée inférieure, à l'encontre du moyen élastique de rappel (6), pour provoquer le déplacement axial du fourreau de protection (5) et de la pointe de touche (4) à leur position sortie de service.

6. Dispositif selon la revendication 4, caractérisé en ce que les moyens de transformation précités comprennent une chaîne de rouleaux (17) reliés entre eux de façon articulée à leurs extrémités par des maillons (18) et emprisonnés dans le logement (11) du boîtier (9) transversalement à l'axe longitudinal de ce boîtier pour définir des rouleaux inférieurs (17) en appui au fond du logement (11) et des rouleaux supérieurs (17) en appui sous des parties correspondantes des deux bords longitudinaux de la fenêtre (9b) en position rétractée de repos du fourreau de protection (5) à laquelle la chaîne est rigide suivant l'axe longitudinal du boîtier de support (9) pour former la butée de fin de course précitée, de sorte qu'en enfonçant l'organe d'actionnement (7), la plaque pivotante (13) exerce sur les rouleaux supérieurs (17) un effort tendant à aplatir la chaîne pour écarter les uns des autres les rouleaux inférieurs (17) à l'encontre du moyen élastique de rappel (6), et provoquer ainsi le déplacement axial du fourreau de protection (5) et de la pointe de touche (4) à leur position sortie de service.

7. Dispositif selon la revendication 4, caractérisé en ce que les moyens de transformation précités comprennent une lame ondulée (19) élastiquement déformable suivant une direction perpendiculaire à son plan médian longitudinal et emprisonnée dans le logement (11) du boîtier de support (9) en étant disposée longitudinalement dans celui-ci suivant l'axe longitudinal du boîtier de support (9) de manière que les ondulations inférieures de la lame (19) soient en appui au fond du logement (11) et les ondulations supérieures de celle-ci soient en appui sous des parties correspondantes des deux bords longitudinaux de la fenêtre (9b) en position rétractée de repos du fourreau de protection (5) à laquelle la lame ondulée (19) est rigide suivant l'axe longitudinal du boîtier de support (9) pour former la butée de fin de course précitée, de sorte qu'en enfonçant l'organe d'actionnement (7), la plaque pivotante (13) exerce sur les ondulations supérieures un effort tendant à aplatir la lame (19), à l'encontre du moyen de rappel élastique (6), pour provoquer le déplacement axial du fourreau de protection (5) et de la pointe de touche (4) à leur position sortie de service.

8. Dispositif selon l'une des revendications 4 à 7, caractérisé en ce que l'organe d'actionnement (7) est en forme de bouton-poussoir solidaire de la plaque pivotante (13) à son extrémité opposée à son axe de pivotement (14) et fait saillie au travers d'une ouverture (8) de la paroi supérieure (la) du corps isolant (1).

9. Dispositif selon l'une des revendications 4 à 7, caractérisé en ce que l'organe d'actionnement (7) est en forme de bouton pivotant à partie excentrée (7b) en contact sur la partie d'extrémité de la plaque pivotante (13) opposée à son axe de pivotement (14) et fait saillie au travers d'une ouverture (8) de la paroi supérieure du corps isolant (1).

10. Dispositif selon l'une des revendications 4 à 9, caractérisé en ce que la plaque pivotante (13) comprend une nervure longitudinale (15) à sa face inférieure en regard de la fenêtre (9b) et pouvant s'engager dans la fenêtre (9b) pour actionner les moyens de transformation (10 ;17 ;19).

11. Dispositif selon l'une des revendications précédentes caractérisé en ce que le moyen élastique de rappel (6) est un ressort hélicoidal de traction fixé d'une part à un ergot en saillie (16) et solidaire du fourreau de protection (5) et traversant une fente longitudinale (9c1) d'une paroi latérale (9c) du boîtier de support (9) et d'autre part à un élément en saillie (12) solidaire du boîtier de support (9) à l'opposé de l'extrémité de contact (4a) de la pointe de touche (4).

12. Dispositif selon l'une des revendications précédentes, caractérisé en ce que le fourreau de protection (5) comprend un plot (5b) faisant saillie au travers d'une autre fente longitudinale (9h) du boîtier de support (9) et permettant de relier électriquement la pointe de touche (4) à un cordon électrique (2).

13. Dispositif selon la revendication 11, caractérisé en ce que le ressort de traction (6), en matériau électriquement conducteur, a son extrémité fixée à l'ergot en saillie (16) du fourreau de protection (5) reliée électriquement à la pointe de touche (4) et son extrémité opposée fixée au boîtier de support (9) reliée électriquement à un cordon électrique (2).

14. Dispositif selon l'une des revendications précédentes, caractérisé en ce que le corps isolant (1) a une partie formant nez (3) dans laquelle est monté à coulissement une partie du fourreau de protection (5) faisant saillie du boîtier de support (9) et l'extrémité de contact (4a) de la pointe de touche (4) fait saillie du fourreau de protection (5) d'une distance telle qu'en position rétractée de repos du fourreau (5), elle est escamotée dans la partie formant nez (3) du corps isolant (1).

15. Dispositif selon l'une des revendications précédentes, caractérisé en ce que le boîtier de support (9) est constitué de deux demi-boîtiers (9c, 9d) fixés amoviblement l'un à l'autre par des vis (12).
